# EUROPEAN PATENT SPECIFICATION

(11) **EP 2 715 226 B1**
(45) Date of publication and mention of the grant of the patent: **08.04.2015**
(21) Application number: 12714368.3
(22) Date of filing: 15.02.2012
(51) Int. Cl.: F21V 29/00

(54) **COOLING OF SEMICONDUCTOR DEVICES**
KÜHLUNG VON HALBLEITERBAUELEMENTEN
REFROIDISSEMENT DE DISPOSITIFS À SEMI-CONDUCTEUR

(30) Priority: 31.05.2011 GB 201109095
(43) Date of publication of application: 09.04.2014
(73) Proprietor: Marulaled (Pty) Ltd, 7800 Diep Rivier (ZA)
(72) Inventor: DE VAAL, Gerardus Geertruud, 7708 Kenilworth (ZA)
(74) Representative: Kramer, Dani
(86) International application number: PCT/IB2012/050693
(87) International publication number: WO 2012/164409

(56) References cited:
- EP-A1- 1 950 491
- WO-A1-2009/148447
- US-A1- 2005 111 234

## Description

### FIELD OF THE INVENTION

The present invention relates to the cooling of semiconductor devices. In particular, the invention relates to assembly and cooling of high power LED's (light emitting diodes) on an ordinary printed circuit board. The invention is described herein with reference to illumination devices incorporating LEDs, but could be applied to any semiconductor devices.

### BACKGROUND TO THE INVENTION

As energy prices escalate and the necessity to save energy increase the demand for LED lighting solutions grow. LEDs being solid state lighting in that they don't burn a filament or a gas, are more efficient than most other forms of lighting. Nevertheless LED's still generate heat from the current that passes through them which can have a detrimental effect on the life span and performance of such devices. When LEDs are clustered in close proximity to each other, overheating may occur, but close clustering of LED's is important as it reduces multiple shadows and so called "dotting".

Currently, in high power LED installations, heat is removed from close clustered LEDs with a combination of heat-sinks, forced flow ventilators and special aluminium printed circuit boards. These methods mostly rely on the conduction of heat through direct contact from the electrodes (thermal pads) of the LEDs towards the back of the printed circuit board, from where the heat spreads into a heat-sink and is dissipated to ambient air. Most heat-sinks are made of aluminium and are energy intensive to produce and have a detrimental effect on the overall (life-cycle) energy efficiencies of such LED lights.

A temperature gradient occurs in such heat-sinks as the temperature drops further away from the centre of the printed circuit board. LEDs placed in the centre of the board will be hotter than LEDs placed on the outside of such a board, with detrimental effects on the performance and/or service life of the LEDs placed at the centre.

Heat is generated by the LEDs on the front of the printed circuit board were the LED's are placed, while the parts intended to remove this heat are placed on the back of the circuit board. The printed circuit board itself forms a barrier for the heat transfer. More expensive aluminium printed circuit boards are used to increase the thermal conductivity towards the back of the circuit board.

Examples of these LED installations include:
WO 2009/067558, US 2008/0191231, US 2002/175621 and US 2005/083698 disclose the use of solid heat-sink elements that extend from the backs of LEDs through the circuit board on which they are mounted, so that heat is transferred from the LEDs by conduction through the heat-sink elements and is dissipated at the back of the circuit board;
US 2007/0145383 discloses a LED installation with the LEDs mounted via base films, onto a heat sink layer on the front of the circuit board;
WO 02/097884 discloses LEDs supported on a metal circuit board, with protrusions on the back of the circuit board;

US 5,278,432 discloses an array of LEDs supported on a heat sink substrate, with the option of a heat-sink at the back of the substrate, with forced air flow.

All these efforts to cool close clustered LEDs lead to an increase in cost and form-factor (i.e. excessive size) of the LED assembly.

WO 2009/148447 discloses a semiconductor device according to the preamble of claim 1.

The present invention seeks to provide an assembly of semiconductors such as LEDs in close proximity on an ordinary printed circuit board with improved cooling of the semiconductors/LEDs, preferably obviating the need for a conventional heat-sink mounted at the back of the circuit board and a costly printed circuit board; and in some instances without the need for inducing forced airflow.

### SUMMARY OF THE INVENTION

According to the present invention there is provided a semiconductor device having the features of claim 1.

At least some of the semiconductors may be LEDs and the substrate sheet may be an ordinary printed circuit board.

The thermally conductive elements may include conductive sheet material extending between the LEDs and the apertures, said conductive sheet material preferably extending along the front surface of the substrate sheet.

At least some of said internal passages may have an orientation extending transversely to the substrate sheet and at least some of the conduits may protrude beyond the back surface of the substrate sheet.

The device may include a ventilator such as a fan, configured to induce a flow of air through the apertures (and though the internal passages of the conduits) in a direction from the front of the substrate sheet to the back of the substrate sheet.

### BRIEF DESCRIPTION OF THE DRAWINGS

For a better understanding of the present invention, and to show how the same may be carried into effect, the invention will now be described by way of non-limiting example, with reference to the accompanying drawings in which:
- Figure 1: shows a front view of a semiconductor assembly in accordance with the present invention;
- Figure 2: shows a side view of the assembly of Figure 1; and
- Figure 3: shows a detailed top view of a part of a printed circuit board of the semiconductor assembly of Figure 1.

### DETAILED DESCRIPTION OF THE DRAWINGS

Referring to the drawings, an illumination device or semiconductor assembly is shown, which includes a substrate sheet in the form of an ordinary printed circuit board (PCB) 2, which is populated by an array of semiconductors in the form of LEDs 4, clustered in close proximity to each other on the top of the PCB. The PCB2 is an "ordinary" PCB in the sense that it is made of a conventional material such as a dielectric/epoxy laminate and it can be a double-sided PCB. A lens 3 is mounted on top of each LED 4 to diffuse or direct the light emitted by the LED.

The assembly is illustrated and described as having a top, side and bottom, but those skilled in the art would be aware that it can be fitted with practically any orientation and references to "top" and "bottom" are used herein only for the sake of clarity. The top of the assembly can instead be regarded as its "front" and the bottom as its "back".

A number of apertures or through holes 9 are defined in the PCB 2 in the free spaces between the lenses 3 and extend between the PCB's top and bottom and conduits in the form of copper tubes 1 are fitted inside the through holes 9, each with a top-bottom orientation and are press fit or soldered onto the PCB. Instead of copper tubes 1, other thermally conductive materials may be used, like graphene. Instead of a cylindrically shaped tubes 1, conduits with a different cross-sectional profile can be used, or at least defining a differently profiled internal passage-especially a profile with increased internal surface area to improve heat transfer and thus reduce the length of tube/conduit required and therefore improving the form factor of the installation. The copper tubes 1 are not necessarily the ideal choice of conduits and their thermal dissipation efficiency could be improved if they had a larger internal area, e.g. if they had internal fins, or the like. However, the copper tubes 1 are easily available, cost-effective (compared to conduits with internal protuberances) can be soldered easily and have a suitable wall thickness - thick enough to conduct heat and thin enough not to encroach on the internal passage.

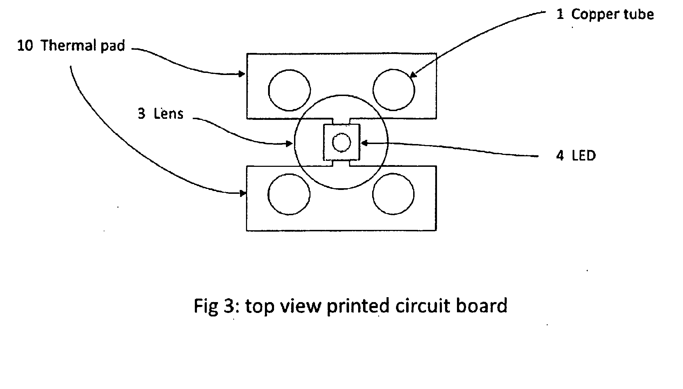

As can best be seen in Figure 3, a thermal pad 10 in the form of a thin layer of thermally conductive material is provided on top of the PCB 2 and extends around each LED 4. The base of the LED 4 is fitted in good thermal contact with the thermal pad 10 and the thermal pad extends around the adjacent through holes 9 and copper tubes 1, so that it provides a path of good heat conductivity from the LED to the copper tubes 1. The insides of the through holes 9 are plated with a good thermal conductor such as copper - to which the copper tubes 1 are fitted by soldering or a press fit, as mentioned above, to provide good thermal contact. Essentially the thermal pads 10 under the LEDs 4 are directly connected to the copper tubes 1 which are instrumental in drawing heat away from the LEDs (see below).

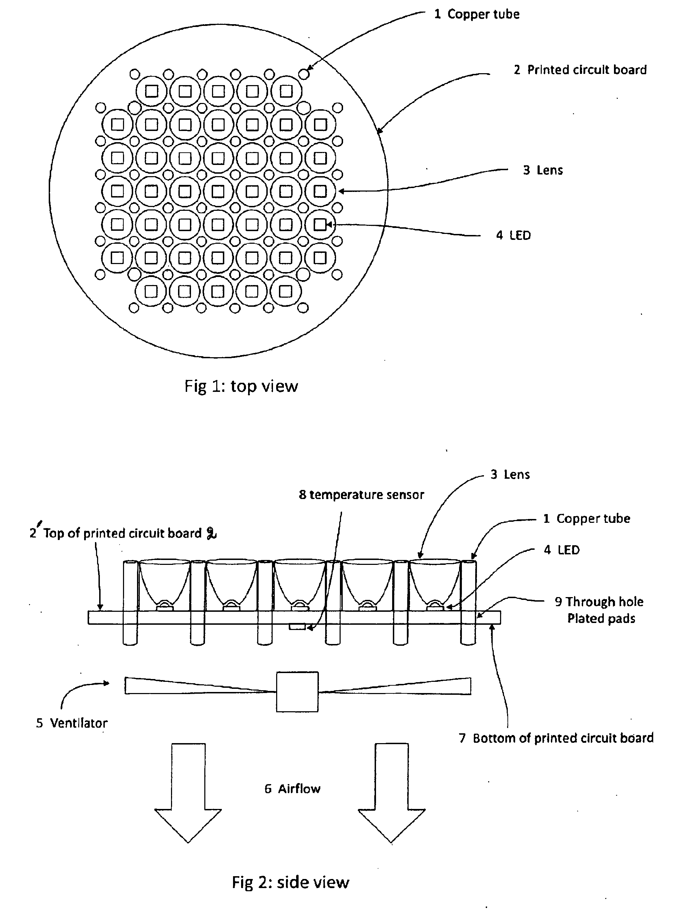

As can best be seen in Figure 2, the length of each of the copper tubes 1 that protrudes on the top of the PCB 2 is longer than that protruding at the bottom 7, so that the tubes extend between the lenses 3. A forced flow ventilator 5 or fan is provided below the PCB 2 and is configured to draw air downwards, as shown by reference numeral 6. A temperature sensor 8 is provided on the bottom 7 of the PCB2 and can be used in a feedback loop to control the temperature of the installation by controlling the speed of the ventilator 5.

In use, heat generated in the LEDs 4 is conducted very effectively via the thermal pads 10 to the copper tubes 1 and heats up the copper tubes. The airflow 6 induced by the ventilator 5 causes a downward flow of air inside the copper tubes 1 and the heat from the LEDs 4 is dissipated (removed) very effectively inside the copper tubes, from the internal walls of the copper tubes to the airflow 6.

In embodiments of the invention where the assembly is inverted, i.e. where the LEDs 4are directed downwards, the heat generated by the LEDs is still conducted to the copper tubes 1, but in some instances, the transfer of heat to air inside the copper tubes can be sufficient to cause an upwards flow of air through natural convection - thus obviating the need for a ventilator 5.

In some embodiments of the invention, the flow of air can be reversed, from the back of the PCB 2 to the front, whether by forced or natural air flow. However, in most applications it is preferable to remove heat from the illuminated area, e.g. where the device is used to illuminate a food store.

Since the copper tubes 1 protrude on the top (front) of the PCB 2, which is the same side as were the LEDs 4 are mounted and where the heat is generated, the heat does not need to be transferred to the bottom (back) of the PCB by conduction only and instead, the heat is removed from the copper tubes 1, by convection, resulting from the fact that air can flow in the passages inside the copper tubes. This is in stark contrast to prior installations, which required a heat sink on the back of the PCB (because it would be impractical or impossible to fit a heat sink on the front of the PCB) and heat had to be conducted through the PCB to the heat sink.

The distances between LEDs 4 and copper tubes 1 are short as every LED is surrounded by copper tubes and since every LED is in close proximity to copper tubes, there is less of a temperature gradient from the centre towards the periphery of the PCB when compared to conventional heat-sinks

Further to the advantages mentioned above, the LED's 4 are cooled very effectively and can thus be used in closer proximity to each other than in prior assemblies, can operate at lower temperatures and/or can operate with higher power output. This superior cooling is achieved without the need for costly thermally conductive PCBs or heat sinks and in some cases, without the need for a ventilator 5.

Also, the assembly of the present invention is significantly more compact (has a smaller form factor) than prior assemblies, largely due to the absence of a large heat sink at the back of the PCB.

The invention holds a particular advantage that airflow 6 is induced (whether by forced ventilation or natural convection) in the direction opposite to the illumination from the LEDs 4 (i.e. front-to-back airflow) and accordingly, the heat is not dissipated or accumulated in the area in front of the assembly that is illuminated by the LEDs.

## Claims

1. A semiconductor illumination device comprising:
a substrate sheet (2) with a front (2') and a back (7) and defining a plurality of apertures (9), each aperture (9) extending between the front (2') and the back (7);
a plurality of semiconductors (4) supported on the front (2') of the substrate sheet (2); and
thermally conductive elements (1,10) that are in good thermal communication with the semiconductors (4) and with the peripheries of the apertures (9);
**characterised in that** at least some of said thermally conductive elements are thermally conductive conduits (1) that are disposed inside the apertures (9) and protrude beyond the front (2') of the substrate sheet (2) and define open passages that extend through the apertures between the front (2') and the back (7) of the substrate sheet (2) without obstruction.

2. An illumination device as claimed in claim 1, wherein at least some of the semiconductors are LEDs (4).

3. An illumination device as claimed in claim 1 or claim 2, **characterised in that** the substrate sheet is an ordinary printed circuit board (2).

4. An illumination device as claimed in any one of the preceding claims, **characterised in that** the thermally conductive elements include conductive sheet material (10) extending between the semiconductors (4) and the apertures (9).

5. An illumination device as claimed in claim 4, **characterised in that** the conductive sheet material (10) extends along the front (2') of the substrate sheet (2).

6. An illumination device as claimed in claim 1, **characterised in that** at least some of said open passages have an orientation extending transversely to the substrate sheet (2).

7. An illumination device as claimed in claim 1 or claim 6, **characterised in that** at least some of said conduits (1) protrude beyond the back (7) of the substrate sheet (2).

8. An illumination device as claimed in any one of the preceding claims, **characterised in that** said device includes a ventilator (5), configured to induce a flow of air (6) through the open passages in a direction from the front (2') of the substrate sheet (2) to the back (7) of the substrate sheet (2).

9. An illumination device as claimed in claim 1, **characterised in that** said thermally conductive conduits (1) are tubes mades out of copper or graphene.

10. An illumination device as claimed in claim 9, **characterised in that** said thermally conductive conduits (1) are cylindrical tubes.

11. An illumination device as claimed in claim 3, **characterised in that the** printed circuit board (2) is a dielectric epoxy laminate.

## Patentansprüche

1. Halbleiterbeleuchtungsvorrichtung, die Folgendes umfasst:
eine Substratplatte (2) mit einer Vorderseite (2') und einer Rückseite (7), die eine Vielzahl von Öffnungen (9) definiert, wobei sich jede Öffnung (9) zwischen der Vorderseite (2') und der Rückseite (7) erstreckt,
eine Vielzahl von Halbleitern (4), die auf der Vorderseite (2') der Substratplatte (2) gestützt sind, und
wärmeleitende Elemente (1, 10), die mit den Halbleitern (4) und mit den Rändern der Öffnungen (9) in gutem thermischen Kontakt stehen;
**dadurch gekennzeichnet, dass** mindestens einige der genannten wärmeleitenden Elemente wärmeleitende Leitungen (1) sind, die in den Öffnungen (9) angeordnet sind und über die Vorderseite (2') der Substratplatte (2) hinausragen und offene Durchgänge definieren, die sich durch die Öffnungen zwischen der Vorderseite (2') und der Rückseite (7) der Substratplatte (2) ohne Behinderung erstrecken.

2. Beleuchtungsvorrichtung nach Anspruch 1, wobei mindestens einige der Halbleiter LEDs (4) sind.

3. Beleuchtungsvorrichtung nach Anspruch 1 oder Anspruch 2, **dadurch gekennzeichnet, dass** die Substratplatte eine herkömmliche Leiterplatte (2) ist.

4. Beleuchtungsvorrichtung nach einem der vorhergehenden Ansprüche, **dadurch gekennzeichnet, dass** die wärmeleitenden Elemente leitendes Plattenmaterial (10) umfassen, das sich zwischen den Halbleitern (4) und den Öffnungen (9) erstreckt.

5. Beleuchtungsvorrichtung nach Anspruch 4, **dadurch gekennzeichnet, dass** sich das leitende Plattenmaterial (10) entlang der Vorderseite (2') der Substratplatte (2) erstreckt.

6. Beleuchtungsvorrichtung nach Anspruch 1, **dadurch gekennzeichnet, dass** mindestens einige der genannten offenen Durchgänge eine Orientierung aufweisen, die sich quer zu der Substratplatte (2) erstreckt.

7. Beleuchtungsvorrichtung nach Anspruch 1 oder Anspruch 6, **dadurch gekennzeichnet, dass** mindestens einige der genannten Leitungen (1) über die Rückseite (7) der Substratplatte (2) hinausragen.

8. Beleuchtungsvorrichtung nach einem der vorhergehenden Ansprüche, **dadurch gekennzeichnet, dass** die genannte Vorrichtung einen Ventilator (5) umfasst, der dafür konfiguriert ist, eine Luftströmung (6) durch die offenen Durchgänge in einer Richtung von der Vorderseite (2') der Substratplatte (2) zu der Rückseite (7) der Substratplatte (2) zu induzieren.

9. Beleuchtungsvorrichtung nach Anspruch 1, **dadurch gekennzeichnet, dass** die genannten wärmeleitenden Leitungen (1) Rohre sind, die aus Kupfer oder Graphen hergestellt sind.

10. Beleuchtungsvorrichtung nach Anspruch 9, **dadurch gekennzeichnet, dass** die wärmeleitenden Leitungen (1) zylindrische Rohre sind.

11. Beleuchtungsvorrichtung nach Anspruch 3, **dadurch gekennzeichnet, dass** die Leiterplatte (2) ein dielektrisches Epoxy-Laminat ist.

## Revendications

1. Dispositif d'éclairage à semiconducteur, comprenant :
une feuille de substrat (2) avec une face avant (2') et une face arrière (7) et définissant une pluralité d'ouvertures (9), chaque ouverture (9) s'étendant entre la face avant (2') et la face arrière (7) ;
une pluralité de semiconducteurs (4) soutenue sur la face avant (2') de la feuille de substrat (2) ; et
des éléments conducteurs thermiques (1, 10) qui sont en bonne communication thermique avec les semiconducteurs (4) et avec les périphéries des ouvertures (9) ;
**caractérisé en ce qu'**au moins quelques-uns desdits éléments conducteurs thermiques sont des conduits conducteurs thermiques (1) qui sont disposés à l'intérieur des ouvertures (9) et dépassent au-delà de la face avant (2') de la feuille de substrat (2), et définissent des passages ouverts lesquels s'étendent sans obstruction à travers les ouvertures entre la face avant (2') et la face arrière (7) de la feuille de substrat (2).

2. Dispositif d'éclairage selon la revendication 1, au moins quelques-uns des semiconducteurs étant des DEL (4).

3. Dispositif d'éclairage selon la revendication 1 ou la revendication 2, **caractérisé en ce que** la feuille de substrat est une plaquette à circuits imprimés ordinaire (2).

4. Dispositif d'éclairage selon l'une quelconque des revendications précédentes, **caractérisé en ce que** les éléments conducteurs thermiques englobent un matériau en feuille conducteur (10) s'étendant entre les semiconducteurs (4) et les ouvertures (9).

5. Dispositif d'éclairage selon la revendication 4, **caractérisé en ce que** le matériau en feuille conducteur (10) s'étend le long de la face avant (2') de la feuille de substrat (2).

6. Dispositif d'éclairage selon la revendication 1, **caractérisé en ce qu'**au moins quelques-uns desdits passages ouverts présentent une orientation s'étendant dans le plan transversal par rapport à la feuille de substrat (2).

7. Dispositif d'éclairage selon la revendication 1 ou la revendication 6, **caractérisé en ce qu'**au moins quelques-uns desdits conduits (1) dépassent au-delà de la face arrière (7) de la feuille de substrat (2).

8. Dispositif d'éclairage selon l'une quelconque des revendications précédentes, **caractérisé en ce que** ledit dispositif englobe un ventilateur (5) lequel est configuré de façon à induire un flux d'air (6) à travers les passages ouverts suivant un sens allant de la face avant (2') de la feuille de substrat (2) vers la face arrière (7) de la feuille de substrat (2).

9. Dispositif d'éclairage selon la revendication 1, **caractérisé en ce que** lesdits conduits conducteurs thermiques (1) sont des tubes fabriqués en cuivre ou en graphène.

10. Dispositif d'éclairage selon la revendication 9, **caractérisé en ce que** lesdits conduits conducteurs thermiques (1) sont des tubes cylindriques.

11. Dispositif d'éclairage selon la revendication 3, **caractérisé en ce que** la plaquette à circuits imprimés (2) est un stratifié époxyde diélectrique.
